# FASCICULE DE BREVET EUROPEEN

(11) **EP 1 856 778 B1**
(45) Date de publication et mention de la délivrance du brevet: **07.04.2010**
(21) Numéro de dépôt: 06709234.6
(22) Date de dépôt: 02.02.2006
(51) Int. Cl.: H01L 21/316

(54) **PROCEDE D'OXYDATION PLANAIRE POUR REALISER UN ISOLANT ENTERRE LOCALISE**
PLANAR-OXIDIERUNGSVERFAHREN ZUR HERSTELLUNG EINES LOKALISIERTEN VERGRABENEN ISOLATORS
PLANAR OXIDATION METHOD FOR PRODUCING A LOCALISED BURIED INSULATOR

(30) Priorité: 07.02.2005 FR 0501201
(43) Date de publication de la demande: 21.11.2007
(73) Titulaire: CENTRE NATIONAL DE LA RECHERCHE SCIENTIFIQUE (CNRS), 75794 Paris Cedex 16 (FR)
(72) Inventeur: CAMPS, Thierry, F- 31500 Toulouse (FR); MUNOZ-YAGUE, Antonio, F-31500 Toulouse (FR); ALMUNEAU, Guilhem, F- 31450 Montlaur (FR); BARDINAL-DELAGNES, Véronique, 31180 Castelmaurou (FR); FONTAINE, Chantal, F- 31400 Toulouse (FR)
(74) Mandataire: Texier, Christian
(86) Numéro de dépôt international: PCT/FR2006/000242
(87) Numéro de publication internationale: WO 2006/082322

(56) Documents cités:
- EP-A- 0 858 137
- EP-A- 1 049 221
- US-A- 5 896 408
- US-A1- 2003 211 642
- US-A1- 2004 264 531
- US-B1- 6 545 335

## Description

La présente invention se rapporte aux procédés d'oxydation planaire pour réaliser un isolant enterré localisé, notamment pour des semiconducteurs de type III-V, selon la classification périodique des éléments de Mendeleiev.

Plus particulièrement, l'invention concerne un procédé de fabrication d'un semiconducteur adapté à la microélectronique, à l'optoélectronique, et à l'optique intégrée par exemple concernant les guides d'ondes, les réseaux de diffraction et les cristaux photoniques.

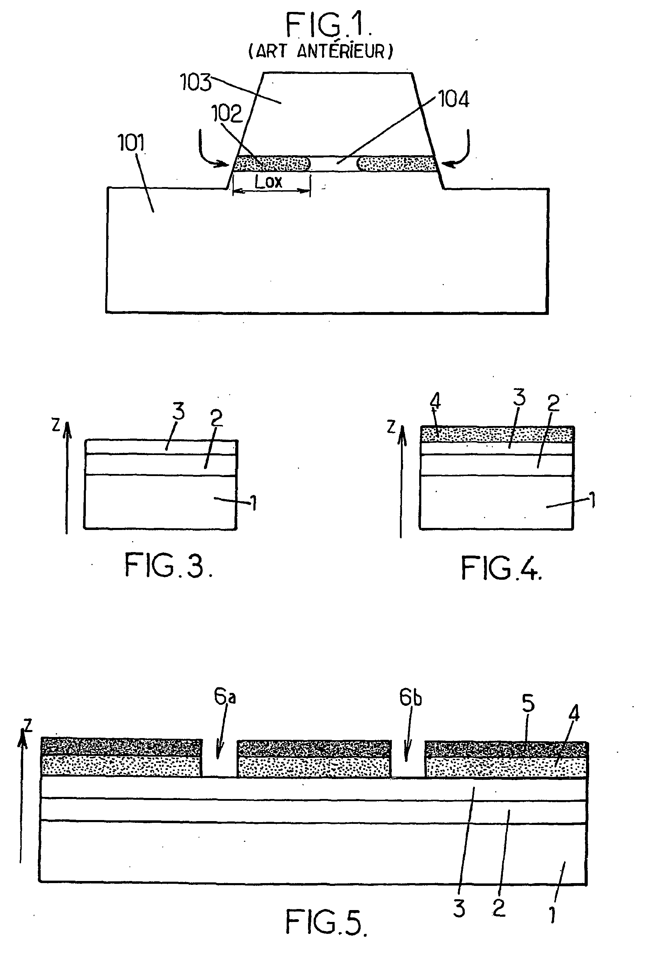

Un procédé d'oxydation latérale d'un semiconducteur est illustré notamment à la figure 1. Dans ce procédé, on forme une première couche de semiconducteur 101. Puis, on forme une deuxième couche de semiconducteur 102, et une troisième couche 103 sur la deuxième couche. On donne à ces deux dernières couches 102 et 103 la forme d'un « mesa », c'est-à-dire d'une portion, faisant saillie sur la surface supérieure de la première couche 101. Cette forme peut par exemple être obtenue par photogravure du composant à semiconducteur.
On peut ensuite procéder à une oxydation latérale en faisant diffuser des espèces oxydantes au travers d'une surface latérale de ce mesa. Ces espèces oxydantes vont oxyder sélectivement la deuxième couche sur une longueur Lₒₓ, en fonction de la diffusion des espèces oxydantes, donc notamment du temps et des conditions d'exposition (température, débit et nature du gaz). La partie centrale de la deuxième couche 104 peut rester non oxydée suivant les applications.

Le document US 5 896 408 présente une variante de ce procédé dans lequel la diffusion se produit horizontalement et radialement.

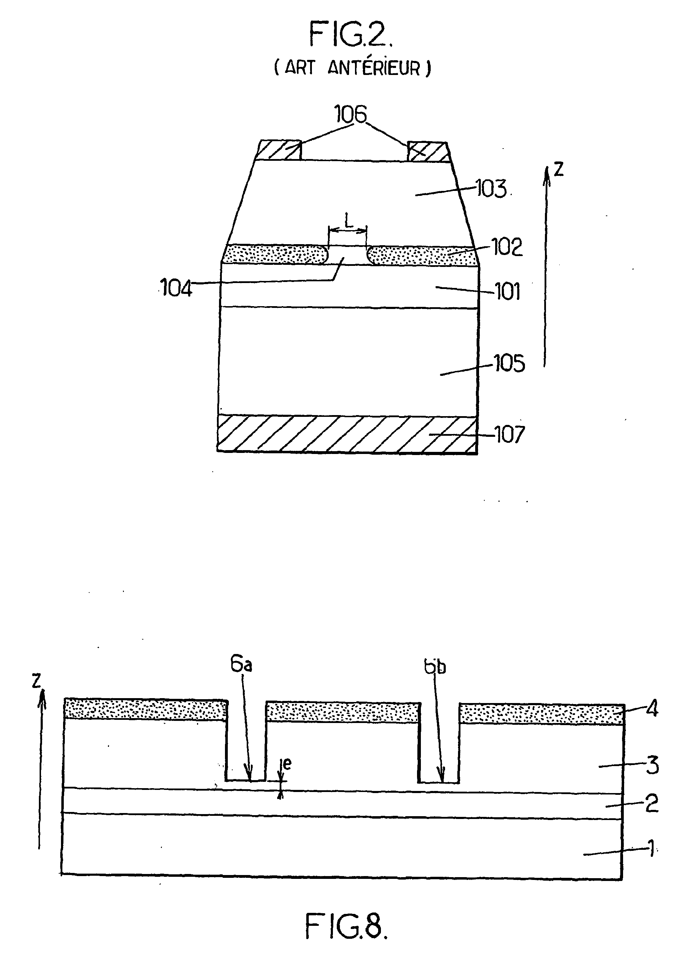

Par exemple, peut utiliser ce type de procédé d'oxydation lors de la fabrication de lasers semiconducteurs à cavité verticale à émission par la surface ou VCSEL (Vertical Cavity Surface Emitting Laser), comme illustré à la figure 2. Pour émettre un rayonnement laser selon la direction Z, un VCSEL comprend une cavité laser 101, par exemple d'épaisseur λ/n, où n est l'indice de réfraction et λ une longueur d'onde de rayonnement. Les couches 103 et 105 forment des miroirs de Bragg, de chaque coté de la cavité 101. Ces couches comprennent en fait un empilement de couches quart d'onde, possédant alternativement un fort indice de réfraction et un faible indice de réfraction. Les portions oxydées de la couche 102, formées par oxydation latérale, forment un diaphragme qui permet d'une part d'imposer le trajet du courant électrique entre des métallisations supérieures 106 et une métallisation inférieure 107, au travers de la portion centrale 104. D'autre part, ce diaphragme permet de limiter les modes latéraux possibles pour l'émission laser, de sorte que le rayonnement laser soit quasi monochromatique. Cependant, ce diaphragme ne doit pas trop limiter la puissance d'émission. Par conséquent, on souhaite avoir une bonne maîtrise de la longueur L de la portion centrale 104.

Cependant, étant donné que la distance L est relativement faible par rapport à la longueur Lₒₓ que doivent parcourir les espèces oxydantes, il existe une grande imprécision sur la maîtrise de cette longueur L, et donc une imprécision sur les performances optoélectroniques du composant. Par conséquent, la reproductibilité est rendue difficile. De plus, ce procédé limite les applications possibles.

Par ailleurs, la formation du « mesa » est assez difficile et empêche que la couche supérieure 103 soit plane, limitant toute reprise d'épitaxie, c'est-à-dire une reprise de croissance d'un cristal, afin de former une couche supérieure. Ainsi, il est très difficile de réaliser des composants multicouches ou d'intégrer ces composants avec d'autres composants. Enfin, ce procédé est difficilement reproductible, et les performances du procédé industriel sont limitées.

La présente invention a notamment pour but de pallier ces inconvénients.

Plus spécifiquement, l'invention a pour but de fournir un procédé de fabrication permettant une plus grande précision dans les motifs d'oxydation et une meilleure définition des couches oxydées.

Par ailleurs, l'invention a pour but de fournir un procédé autorisant une meilleure industrialisation.

A cet effet, selon une définition actuellement acceptée de l'invention, un procédé du type en question est caractérisé en ce qu'il comprend les étapes suivantes de :
(a) formation d'une première couche de semiconducteur ;
(b) formation d'une deuxième couche de semiconducteur au-dessus de la première couche de semiconducteur, selon une direction de formation Z, une concentration d'espèces pouvant être oxydées dans la première couche étant sensiblement plus faible qu'une concentration d'espèces pouvant être oxydées dans la deuxième couche ;
(c) formation d'une troisième couche de semiconducteur au-dessus de la deuxième couche de semiconducteur, selon la direction de formation Z, une concentration d'espèces pouvant être oxydées dans la troisième couche étant sensiblement plus faible que la concentration d'espèces pouvant être oxydées dans la deuxième couche ;
(d) formation d'au moins une zone de diffusion sur la troisième couche ;
(e1) diffusion d'espèces oxydantes dans le matériau de la troisième couche selon une direction générale de diffusion parallèle à la direction de formation Z;
(e2) oxydation de la deuxième couche par diffusion d'espèces oxydantes au travers de la zone de diffusion de la troisième couche.
   Grâce à ces dispositions, l'invention peut fournir un procédé de fabrication d'un dispositif à semiconducteur totalement planaire. Par conséquent, il est possible de réaliser une reprise d'épitaxie sur la couche supérieure du composant électronique pour former un composant multicouche. De plus, en raison de la plus faible épaisseur de matériau à traverser pour former la couche, ce procédé permet une plus grande vitesse de réalisation de composants et une plus grande précision de la longueur des zones non oxydées. Enfin, cette oxydation permet d'envisager des motifs complexes non accessibles au procédé de type mesa, et peut être réalisée au moyen de masques. Par ailleurs, il est possible de réaliser des composants tels des guides d'ondes optiques intégrés, ou tout autre structure optique périodique ou non profitant du contraste d'indice de réfraction entre les couches oxydées et non oxydées.
   Dans divers modes de réalisation du procédé selon l'invention, on peut éventuellement avoir recours en outre à l'une et/ou à l'autre des dispositions suivantes :
   - au cours de l'étape (c), on forme la troisième couche de sorte que son épaisseur selon la direction de formation Z au moins au niveau de la zone de diffusion est comprise entre 5 et 100 nm ;
   - l'étape (d) comprend la formation d'un masque, réalisé par lithographie suivie d'une gravure du masque au voisinage de ladite zone de diffusion ;
   - l'étape (d) est réalisée par gravure de la troisième couche au moins au niveau de la zone de diffusion, sur une profondeur prédéterminée selon la direction de formation Z inférieure à l'épaisseur de ladite troisième couche selon la direction de formation ;
   - l'étape (e) est réalisée sous une atmosphère comprenant un mélange d'un gaz vecteur et de vapeur d'eau ;
   - le gaz vecteur comprend au moins l'un des gaz parmi les suivantes : hydrogène, azote, argon, azote hydrogéné ;
   - l'étape (e) est réalisée à une température supérieure à 300°C ;
   - le procédé comprend de plus les étapes consistant à :
(f) la formation d'une quatrième couche ;
(g) la formation d'une cinquième couche sur la quatrième couche, selon la direction de formation Z, une concentration d'espèces pouvant être oxydées dans la quatrième couche étant sensiblement plus faible qu'une concentration d'espèces pouvant être oxydées dans la cinquième couche ;
   les étapes (f) et (g) étant réalisées préalablement à l'étape (a), la première couche étant formée sur la cinquième couche au cours de l'étape (a) selon la direction de formation Z ;
   - le procédé comprend de plus une étape (h) d'attaque du reste du masque sur la troisième couche ;
   - le procédé comprend de plus une étape (i) consistant à la reprise d'épitaxie sur la troisième couche ;
   - le semiconducteur est un semiconducteur de type III-V, selon la classification périodique des éléments de Mendeleïev.

Par ailleurs, l'invention a également pour objet un semiconducteur pouvant être obtenu par la mise en oeuvre du procédé conforme à l'invention.

D'autres caractéristiques et avantages de l'invention apparaîtront au cours de la description suivante d'un de ses modes de réalisation, donné à titre d'exemple non limitatif, en regard des dessins joints.

Sur les dessins :
- la figure 1, déjà décrite, représente un procédé de fabrication de dispositif à semiconducteur selon l'art antérieur ;
- la figure 2, déjà décrite représente un VCSEL ;
- la figure 3 illustre un dispositif à semiconducteur en cours de réalisation selon un procédé conforme à l'invention ;
- la figure 4 illustre un dispositif à semiconducteur en cours de réalisation selon un procédé conforme à l'invention ;
- la figure 5 illustre un dispositif à semiconducteur en cours de réalisation selon un procédé conforme à l'invention ;
- la figure 6 illustre un dispositif à semiconducteur en cours de réalisation selon un procédé conforme à l'invention ;
- la figure 7 illustre un dispositif à semiconducteur après la réalisation selon un procédé conforme à l'invention ;
- la figure 8 illustre un dispositif à semiconducteur en cours de réalisation selon une première variante de procédé conforme à l'invention ;
- la figure 9 illustre un dispositif à semiconducteur en cours de réalisation selon une deuxième variante de réalisation.

Sur les différentes figures, les mêmes références désignent des éléments identiques ou similaires.

Comme représenté à la figure 3, afin de former un composant à semiconducteur conformément à l'invention, on réalise la superposition de trois couches semiconductrices 1, 2 et 3, dans cet ordre selon la direction Z, par épitaxie, les unes sur les autres. Par couche on entend une couche ou bien un ensemble de sous-couches. La première couche 1 est par exemple la couche inférieure, et on forme sur cette couche une deuxième couche 2. Alors que la première couche 1 peut comprendre en majorité de l'arséniure de gallium (GaAs) ou bien de l'arséniure de gallium à faible taux en aluminium (AlGaAs) (un taux inférieur à 70%), la deuxième couche 2 est riche en espèces pouvant être oxydées, ici de l'aluminium. Par exemple, la deuxième couche peut être formée en majorité d'arséniure d'aluminium (AlAs) ou bien de l'arséniure de gallium à fort taux en aluminium (AlGaAs) (un taux supérieur à 70%). A l'instar de la première couche, la troisième couche 3 peut comprendre peu d'espèces pouvant être oxydées, et être formée de GaAs, ou de AlGaAs à faible taux en aluminium.

On peut cependant transposer ce procédé pour des semiconducteurs autres que des semiconducteurs de type III-V, selon la classification périodique des éléments de Mendeleïev. Par exemple, pour des semiconducteurs de type IV-IV, on peut utiliser du Ge(Si) pour les première et troisième couches, et pour la deuxième couche du Si, l'espèce pouvant être oxydées étant le Si. De même, on peut transposer ce procédé d'oxydation pour des semiconducteurs de type II-VI.

Puis, afin de réaliser un motif desiré, on utilise un procédé de lithographie et gravure par exemple. Ainsi, comme illustré à la figure 4, on peut déposer sur la surface supérieure selon la direction Z, par exemple ici sur la troisième couche 3, un matériau de masquage 4. Ce matériau de masquage 4 peut être déposé sur la troisième couche 3 par dépôt chimique en phase vapeur, par exemple par dépôt en phase vapeur assisté par Plasma ou PECVD (Plasma Enhanced Chemical Vapor Deposition), ou par centrifugation. Ce matériau 4 peut comprendre par exemple un diélectrique, tels le SiNx ou le SiO2, ou le SrF2.

Une fois le matériau de masquage 4 déposé, une couche photosensible 5, illustrée à la figure 5 est déposée. Puis, on expose cette couche photosensible 5 à un rayonnement lumineux ultraviolet par exemple selon le motif désiré. Ainsi, la couche photosensible 5 peut être au moins partiellement modifiée et devient révélable là où celle-ci a été exposée. Après révélation, on peut réaliser les ouvertures 6a et 6b par une gravure (par voie humide ou voie sèche) du matériau de masquage 4.

Il est ainsi possible de former simplement un masque ayant la forme adéquate pour réaliser ensuite le composant semiconducteur. On pourra ensuite oxyder le matériau semiconducteur selon la forme de ce masque.

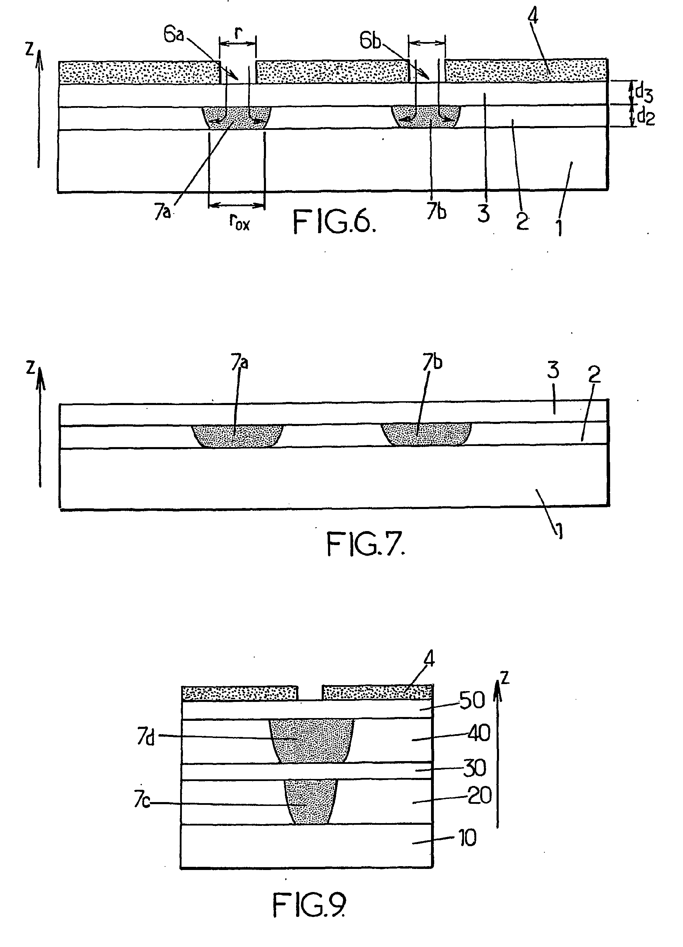

Comme illustré à la figure 6, on réalise ensuite une oxydation de la deuxième couche 2 au travers de la troisième couche 3. Pour effectuer cela, il est possible de placer, pendant une durée pouvant comprise entre 2 et 10 minutes, le dispositif à semiconducteur dans un four à une température supérieure à 300°C pour AlGaAs, de préférence au voisinage de 400°C, et sous une atmosphère comprenant un mélange d'espèces oxydantes, comme de l'azote hydrogéné, chargée de vapeur d'eau par exemple. Dans le cas de semiconducteur utilisant InP, on préfère par exemple une température de 500°C.

Dans ces conditions, les espèces oxydantes vont diffuser au travers de la troisième couche 3 sans l'oxyder, car celle-ci comporte peu ou pas d'espèces pouvant être oxydées à cette température. En atteignant la deuxième couche 2, riche en espèces pouvant être oxydées à cette température, les espèces oxydantes vont réagir pour former des îlots d'oxyde isolant 7a et 7b.

Afin de faciliter la diffusion des espèces oxydantes au travers de la couche 3, il est préférable que celle-ci soit d'épaisseur d3 relativement faible selon la direction Z comprise entre 10 et 50 nm, tandis que l'épaisseur d2 selon la direction Z est supérieure à 20nm, typiquement entre 20 et 100nm pour les VCSELs. On assure ainsi une bonne diffusion au travers de la troisième couche 3 et une bonne oxydation de la deuxième couche 2.

Une fois la portion oxydée formée, on peut retirer entièrement le masque 4, comme illustré à la figure 7. Puis, il est possible de former une couche supplémentaire au-dessus de la troisième couche, par épitaxie par exemple. On peut ainsi créer des composants multicouches complexes.

Selon une variante de réalisation représentée à la figure 8, on peut former la troisième couche 3 avec une épaisseur plus importante selon la direction de formation Z, par exemple 200nm. Puis, on réalise un masque 4 sur la troisième couche 3 et on attaque cette couche 3 sur une profondeur déterminée pour former les fossés 6a et 6b. Le fond des fossés 6a et 6b forme des zones de diffusion. L'épaisseur e de la troisième couche au niveau des zones de diffusion est assez faible pour permettre la diffusions des espèces oxydantes au travers de la troisième couche 3, par exemple 20nm, tandis que l'épaisseur de la troisième couche 3 aux endroits non attaqués est de 200nm et ne permet pas une diffusion au travers. Puis, on retire le masque 4, et on oxyde des manière identique au mode de réalisation précédent.

Cette variante permet d'éviter de placer le masque dans le four. En effet, si ce masque subit une haute température, celui-ci devient difficile à retirer et la surface de la troisième couche 3 pourrait être détériorée. Par conséquent, en utilisant cette variante, la reprise d'épitaxie sur la troisième couche 3 est simplifiée.

Il a été remarqué que lors de la mise en oeuvre de ce procédé selon l'une des variantes décrites précédemment, les îlots oxydés 7a et 7b s'étalent légèrement de manière transversale à la direction de formation Z. Ainsi, la largeur rₒₓ de la portion oxydée 7a ou 7b selon cette direction Z est plus grande que la largeur r de l'ouverture dans le masque 6a ou 6b. De plus, la largeur rₒₓ est d'autant plus grande que le temps d'oxydation est grand ou que la concentration en espèces oxydantes dans l'atmosphère est grande. Ainsi, il est possible de maîtriser le dépassement de ces îlots oxydés 7a et 7b en ajustant l'épaisseur de la couche à oxyder, le temps, la température ou encore la concentration des espèces oxydantes. Il est de plus possible de tenir compte de ces dépassements lors de la conception et d'adapter le motif du masque en fonction de ces dépassements.

De plus, on peut jouer sur la forme des dépassements, par exemple en modifiant le profil de concentration d'espèces pouvant être oxydées dans la couche à oxyder.

Selon un autre mode de réalisation illustré à la figure 9, il est possible d'oxyder une pluralité de couches superposées simultanément. Ainsi, le compostant semiconducteur peut comporter cinq couches, ou plus. Les couches 10, 20, 30, 40 et 50, peuvent être formées comme précédemment, par épitaxie, par exemple dans cet ordre. De manière comparable au mode de réalisation précédent, les couches 30 et 50 ne comportent pas d'espèces pouvant être oxydées, à l'inverse de la couche 40. De même, la couche 20 a une forte concentration en espèces pouvant être oxydées. La couche 10 ne comporte pas d'espèces pouvant être oxydées.

De manière similaire à la première variante de réalisation, on forme un masque 4 au dessus de la couche supérieure 50, et on procède à l'oxydation. Par diffusion au travers de la couche 50, les espèces oxydantes oxydent la couche 40 pour former la portion oxydée 7d, sans oxyder la couche 50. Cependant, celles-ci peuvent ensuite diffuser au travers de la couche 30 sans l'oxyder, et oxyder ensuite la couche 20 pour former la couche 7c.

Par conséquent, en une seule oxydation, on procède à la formation d'une pluralité d'îlots oxydés superposés. Afin de réaliser cette multiple oxydation, il est préférable que les couches 30 et 50 au travers desquelles passent les espèces oxydantes soient d'épaisseurs faibles. De plus, la largeur de la portion oxydée 7c est plus faible que la largeur de la portion oxydée 7d.

Cependant, il est possible d'adapter les concentrations, ou l'épaisseur des deuxième et quatrième couches 20 et 40, afin de modifier la largeur, la forme et l'étendue des îlots oxydés 7c et 7d. En effet, plus l'épaisseur de la couche à oxyder est faible et plus les dépassements sont réduits, car les espèces oxydantes ont plus de difficultés pour diffuser.

La fin du procédé de fabrication selon cette variante est identique au procédé préalablement décrit.

## Revendications

1. Procédé de fabrication d'un semiconducteur **caractérisé en ce qu'**il comprend les étapes suivantes de :
(a) formation d'une première couche (1, 30) de semiconducteur ;
(b) formation d'une deuxième couche (2, 40) de semiconducteur, au dessus de la première couche de semiconducteur, selon une direction de formation Z, une concentration d'espèces pouvant être oxydées dans la première couche (1, 30) étant sensiblement plus faible qu'une concentration d'espèces pouvant être oxydées dans la deuxième couche (2, 40) ;
(c) formation d'une troisième couche (3, 50) de semiconducteur au-dessus de la deuxième couche (2, 40) de semiconducteur, selon la direction de formation Z, une concentration d'espèces pouvant être oxydées dans la troisième couche (3, 50) étant sensiblement plus faible que la concentration d'espèces pouvant être oxydées dans la deuxième couche (2, 40);
(d) formation d'au moins une zone de diffusion sur la troisième couche (3, 50) ;
(e1) diffusion d'espèces oxydantes dans le matériau de la troisième couche (3, 50) selon une direction générale de diffusion parallèle à la direction de formation,
(e2) oxydation de la deuxième couche (2, 40) par diffusion d'espèces oxydantes au travers de la troisième couche.

2. Procédé selon la revendication 1, dans lequel au cours de l'étape (c), on forme la troisième couche (3, 50) de sorte que son épaisseur selon ladite direction de formation Z au moins au niveau de la zone de diffusion est comprise entre 5 et 100 nm.

3. Procédé selon la revendication 1 ou la revendication 2, dans lequel l'étape (d) comprend la formation d'un masque (4), réalisé par lithographie suivie d'une gravure du masque au voisinage de ladite zone de diffusion.

4. Procédé selon la revendication 1 ou la revendication 2, dans lequel l'étape (d) est réalisée par gravure de la troisième couche (3, 50) au moins au niveau de la zone de diffusion, sur une profondeur prédéterminée selon la direction de formation Z inférieure à l'épaisseur de ladite troisième couche selon la direction de formation.

5. Procédé selon l'une des revendications précédentes, dans lequel l'étape (d) est réalisée par lithographie.

6. Procédé selon l'une des revendications précédentes, dans lequel l'étape (e) est réalisée sous une atmosphère comprenant un mélange d'un gaz vecteur et de vapeur d'eau.

7. Procédé selon la revendication 6, dans lequel le gaz vecteur comprend au moins l'un des gaz parmi les suivants : hydrogène, azote, argon, azote hydrogéné.

8. Procédé selon l'une des revendications précédentes, dans lequel l'étape (e) est réalisée à une température supérieure à 300°C.

9. Procédé selon l'une des revendications précédentes, comprenant de plus les étapes consistant à :
(f) la formation d'une quatrième couche (10) ;
(g) la formation d'une cinquième couche (20) sur la quatrième couche, selon la direction de formation Z, une concentration d'espèces pouvant être oxydées dans la quatrième couche (10) étant sensiblement plus faible qu'une concentration d'espèces pouvant être oxydées dans la cinquième couche (20) ; les étapes (f) et (g) étant réalisées préalablement à l'étape (a), la première couche (30) étant formée sur la cinquième couche (20) au cours de l'étape (a) selon la direction de formation Z.

10. Procédé selon la revendication 3, comprenant de plus une étape (h) d'attaque du reste du masque (4) sur la troisième couche (3, 50), après oxydation.

11. Procédé selon l'une quelconque des revendications précédentes, comprenant de plus une étape (i) consistant à une épitaxie sur la troisième couche (3, 50).

12. Procédé selon l'une des revendications précédentes dans lequel le semiconducteur est un semiconducteur de type III-V, selon la classification périodique des éléments de Mendeleïev.

## Claims

1. A process for the manufacture of a semiconductor **characterised in that** it includes the following stages for:
(a) formation of a first semiconductor layer (1, 30);
(b) formation of a second semiconductor layer (2, 40) on top of the first semiconductor layer, in formation direction Z, with a concentration of species capable of being oxidised in the first layer (1, 30) being sensibly lower than a concentration of species capable of being oxidised in the second layer (2, 40);
(c) formation of a third semiconductor layer (3, 50) on top of the second semiconductor layer (2, 40), in formation direction Z, with a concentration of species capable of being oxidised in the third layer (3, 50) being sensibly lower than the concentration of species capable of being oxidised in the second layer (2, 40);
(d) formation of at least one diffusion zone on the third layer (3, 50);
(e1) diffusion of oxidising species in the third layer (3, 50), in a general direction of diffusion parallel to the formation direction Z,
(e2) oxidation of the second layer (2, 40) by diffusion of oxidising species through the third layer.

2. A process according to claim 1, in which, in the course of stage (c), the third layer (3, 50) is formed so that its thickness in said formation direction Z, at least at the level of the diffusion zone, is between 5 and 100 nm.

3. A process according to claim 1 or claim 2, in which stage (d) includes the formation of a mask (4), produced by lithography followed by etching of the mask in the vicinity of said diffusion zone.

4. A process according to claim 1 or claim 2, in which stage (d) is achieved by etching of the third layer (3, 50) at least at the level of the diffusion zone, over a predetermined depth in formation direction Z that is less than the thickness of said third layer in the formation direction.

5. A process according to one of the preceding claims, in which stage (d) is effected by lithography.

6. A process according to one of the preceding claims, in which stage (e) is effected in an atmosphere that includes a mixture of a vector gas and water vapour.

7. A process according to claim 6, in which the vector gas includes at least one of the following gases: hydrogen, nitrogen, argon, nitrogen hydrogen.

8. A process according to one of the preceding claims, in which stage (e) is effected at a temperature of more than 300°C.

9. A process according to one of the preceding claims, that also includes stages consisting of:
(f) the formation of a fourth layer (10);
(g) the formation of a fifth layer (20) on the fourth layer, in formation direction Z, with a concentration of species capable of being oxidised in the fourth layer (10) being sensibly lower than a concentration of species capable of being oxidised in the fifth layer (20);
with stages (f) and (g) being effected prior to stage (a), the first layer (30) being formed on the fifth layer (20) in the course of stage (a) in formation direction Z.

10. A process according to claim 3, and also including a stage (h) for attacking the rest of the mask (4) in the third layer (3, 50) after oxidation.

11. A process according to any of the preceding claims, which also includes a stage (i) consisting of an epitaxy on the third layer (3, 50).

12. A process according to one of the preceding claims, in which the semiconductor is a type III-V semiconductor, according to the Mendeleev periodic element classification.

## Patentansprüche

1. Verfahren zur Herstellung eines Halbleiters,
**dadurch gekennzeichnet, dass** es die folgenden Schritte umfasst:
a) Bildung einer ersten Halbleiter-Schicht (1, 30),
b) Bildung einer zweiten Halbleiter-Schicht (2, 40) über der ersten Halbleiter-Schicht gemäß einer Bildungsrichtung Z, wobei eine Verbindungskonzentration in der ersten Schicht (1, 30) oxidierbar ist, die etwa schwächer ist als eine Konzentration von Verbindungen, die in der zweiten Schicht (2, 40) oxydierbar sind,
c) Bildung einer dritten Halbleiter-Schicht (3, 50) über der zweiten Halbleiter-Schicht (2, 40) gemäß einer Bildungsrichtung Z, wobei eine Verbindungskonzentration in der dritten Schicht (3, 50) oxidierbar sind, die etwa schwächer ist als die Konzentration von Verbindungen, die in der zweiten Schicht (2, 40) oxydierbar sind,
d) Bildung mindestens eines Diffusionsbereichs auf der dritten Schicht (3, 50),
e1) Diffusion oxidierender Verbindungen im Werkstoff der dritten Schicht (3, 50) gemäß einer allgemeinen Diffusionsrichtung parallel zur Bildungsrichtung Z,
e2) Oxidation der zweiten Schicht (2, 40) durch Diffusion oxidierender Verbindungen durch die dritte Schicht.

2. Verfahren nach Anspruch 1, wobei im Schritt c) die dritte Schicht (3, 50) derart gebildet wird, dass ihre Dicke gemäß der Bildungsrichtung Z mindestens auf Ebene des Diffusionsbereichs zwischen 5 und 100 nm inklusive ist.

3. Verfahren nach Anspruch 1 oder Anspruch 2, wobei der Schritt d) die Bildung einer Maske (4) umfasst, die durch Lithographie, gefolgt von einer Gravur der Maske in Nachbarschaft des Diffusionsbereichs, durchgeführt wird.

4. Verfahren nach Anspruch 1 oder Anspruch 2, wobei der Schritt d) durch Gravur der dritten Schicht (3, 50) mindestens auf Ebene des Diffusionsbereichs durchgeführt wird über eine vorbestimmte Tiefe gemäß der Bildungsrichtung Z, die geringer ist als die Dicke der dritten Schicht gemäß der Bildungsrichtung.

5. Verfahren nach einem der vorangehenden Ansprüche, wobei der Schritt d) durch Lithographie durchgeführt wird.

6. Verfahren nach einem der vorangehenden Ansprüche, wobei der Schritt e) in einer Atmosphäre durchgeführt wird, die ein Gemisch eines Vektorgases und von Wasserdampf umfasst.

7. Verfahren nach Anspruch 6, wobei das Vektorgas mindestens eines der folgenden Gase Wasserstoff, Stickstoff, Argon, Wasserstoffstickstoff umfasst.

8. Verfahren nach einem der vorangehenden Ansprüche, wobei der Schritt e) bei einer Temperatur über 300 °C durchgeführt wird.

9. Verfahren nach einem der vorangehenden Ansprüche, das zusätzlich die Schritte umfasst, die bestehen in:
f) der Bildung einer vierten Schicht (10),
g) der Bildung einer fünften Schicht (20) auf der vierten Schicht gemäß der Bildungsrichtung Z, wobei eine Verbindungskonzentration in der vierten Schicht (10) oxidierbar ist, die etwa schwächer ist als eine Konzentration von Verbindungen, die in der fünften Schicht (20) oxidierbar sind,
wobei die Schritte f) und g) vor dem Schritt a) durchgeführt werden, wobei die erste Schicht (30) auf der fünften Schicht (20) während Schritt a) gemäß der Bildungsrichtung Z gebildet wird.

10. Verfahren nach Anspruch 3, das zusätzlich einen Angriffsschritt h) der restlichen Maske (4) auf der dritten Schicht (3, 50) nach Oxidation umfasst.

11. Verfahren nach einem der vorangehenden Ansprüche, das zusätzlich einen Schritt i) umfasst, der in einer Epitaxie auf der dritten Schicht (3, 50) besteht.

12. Verfahren nach einem der vorangehenden Ansprüche, wobei der Halbleiter gemäß der periodischen Klassifizierung der Elemente von Mendelejew ein Halbleiter Typ III-V ist.
